# EUROPÄISCHE PATENTANMELDUNG

(11) **EP 0 546 453 A1**
(43) Veröffentlichungstag der Anmeldung: **16.06.1993**
(21) Anmeldenummer: 92120679.3
(22) Anmeldetag: 04.12.1992
(51) Int. Cl.: G01R 15/02, H01F 27/28

(54) **Messwandler für statische Elektrizitätszähler**

(30) Priorität: 13.12.1991 CH 3672/91
(71) Anmelder: ZELLWEGER LUWA AG, CH-8610 Uster (CH)
(72) Erfinder: Warmerdam, Petrus, CH-8620 Wetzikon (CH)
(74) Vertreter: Dittrich, Horst

(57) **Zusammenfassung**

Der Messwandler enthält einen den zu messenden Strom führenden Primärleiter (1) und eine mit diesem magnetisch gekoppelte Sekundärspule (2). Der Primärleiter (1) ist spiralartig geformt und bildet einen Körper in der Art einer Spiralfeder, welcher die Sekundärspule (2) mit mindestens einer Windung umfasst. Der Zylinder ist vorzugsweise durch ein Rohr (4) mit einer dessen Wandung durchstossenden, spiralförmigen Nut (5) gebildet.

Der Primärleiter besitzt eine sehr hohe Eigenstabilität, so dass für die Sekundärspule keine speziellen Haltemittel erforderlich sind. Die Sekundärspule ist im Primärleiter äusserst einfach zu montieren und es ergeben sich keine Probleme mit Montagetoleranzen und dergleichen.

## Beschreibung

Die vorliegende Erfindung betrifft einen Messwandler für statische Elektrizitätszähler, mit einem den zu messenden Strom führenden Primärleiter und mit einer mit diesem magnetisch gekoppelten Sekundärspule.

Bei einem aus der EP-A-262 293 bekannten Messwandler dieser Art ist der Primärleiter zu einem U-förmigen Bügel geformt und umfasst mit seiner Nase die einen an die U-Form des Strombügels angepassten Querschnitt aufweisende Sekundärspule. Die letztere ist in einem Gehäuse angeordnet und bildet mit diesem zusammen eine Baueinheit, was eine einfache und gegenüber mechanischen Toleranzen unkritische Montage der Sekundärspule zwischen den Schenkeln des den Primärleiter bildenden Strombügels gestatten soll.

Durch die Erfindung soll nun ein Messwandler angegeben werden, bei dem keine spezielle Halterung für die Sekundärspule erforderlich und der trotzdem einfach zu montieren und unkritisch gegenüber Toleranzen ist. Ausserdem soll die magnetische Kopplung zwischen Primärleiter und Sekundärspule möglichst optimal sein.

Diese Aufgabe wird erfindungsgemäss dadurch gelöst, dass der Primärleiter schraubenförmig ausgebildet ist und einen Körper in der Art einer Spiralfeder bildet, welcher die Sekundärspule mit mindestens einer Windung umfasst.

Ein bevorzugtes Ausführungsbeispiel des erfindungsgemässen Messwandlers ist dadurch gekennzeichnet, dass der genannte durch den Primärleiter gebildete Körper durch ein Rohr mit einer dessen Wandung durchstossenden, schraubenförmigen Nut gebildet ist.

Durch die erfindungsgemässe Ausbildung des Primärleiters ist die Sekundärspule an ihrem gesamten Umfang vom Primärleiter umschlossen. Dadurch ist der Abstand zwischen der gesamten Mantelfläche der Sekundärspule und dem Primärleiter jeweils gleich gross, woraus sich ein optimal homogenes Magnetfeld und eine sehr gute magnetische Kopplung ergibt. Ausserdem besitzt der rohrförmige Primärleiter eine so hohe Eigenstabilität, dass für die Sekundärspule keine zusätzlichen Haltemittel erforderlich sind. Zur Montage wird die Sekundärspule einfach in das vom Primärleiter gebildete Rohr gesteckt, so dass sich auch keinerlei Probleme mit Montagetoleranzen und dergleichen ergeben.

Nachstehend wird die Erfindung anhand von Ausführungsbeispielen und der Zeichnungen näher erläutert; es zeigt:
Fig. 1 eine Ansicht eines erfindungsgemässen Messwandlers bei abgenommener magnetischer Abschirmung,
Fig. 2 einen Schnitt nach der Linie 11-11 von Fig. 1,
Fig. 3 einen Schnitt nach der Linie 111-111 von Fig. 1,
Fig. 4 eine erste Variante des Primärleiters des Messwandlers,
Fig. 5 eine zweite Variante des Primärleiters,
Fig. 6 eine Ansicht in Richtung des Pfeiles VI von Fig. 5; und
Fig. 7 einen Schnitt durch ein mit dem Primärleiter von Fig. 5 ausgerüstetes Messmodul eines Elektrizitätszählers.

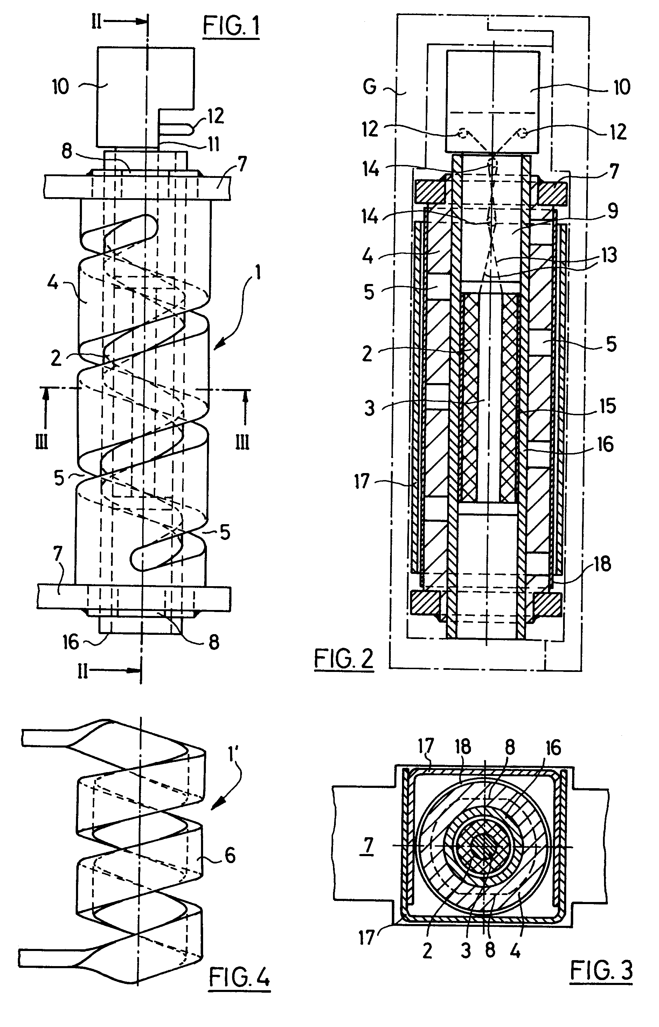

Gemäss den Figuren 1 bis 3, welche im Massstab von etwa 3:1 gehalten sind, umfasst der erfindungsgemässe Messwandler im wesentlichen einen Primärleiter 1 und eine von diesem umfasste Sekundärspule 2, welche von einem Spulenkörper 3 getragen ist. Der Primärleiter 1 ist durch ein Kupferrohr 4 gebildet, in welches eine schraubenförmige Nut 5 eingefräst ist, so dass der Primärleiter funktionsmässig einem schraubenförmig aufgewickelten Band entspricht, dessen Steigung pro Umgang grösser ist als die Breite des Bandes. In Fig. 4 ist eine Alternativlösung eines Primärleiters 1' dargestellt, welcher durch ein in der erwähnten Art aufgewickeltes Kupferband 6 gebildet ist.

Das Kupferrohr 4 ist an seinen stirnseitigen Enden je in ein Flachprofil 7 aus Kupfer eingelötet, welches zur Zu- und Ableitung des zu messenden Stroms zum bzw. vom Kupferrohr 4 dient. Wie den Fig. 1 und 3 zu entnehmen ist, weist das Kupferrohr 4 an seinem mit den Flachprofilen 7 zu verlötenden Enden zwei Abflachungen 8 auf, welche zusammen mit einer entsprechenden schlüsselmaulartigen Formgebung der zur Aufnahme des Kupferrohrs 4 vorgesehenen Bohrung des Flachprofils 7 als Verdrehungsschutz beim Verlöten dienen.

Der rohrförmige Primärleiter 1 bildet zusammen mit den beiden Flachprofilen 7 einen ausserordentlich stabilen Bauteil, welcher die ganze transformatorische Messanordnung zusammenhalten kann, ohne dass zusätzliche Haltemittel erforderlich sind. Der genannte Bauteil ist zum Einbau in ein flaches, schachtelförmiges Messmodul vorgesehen, wie es in der EP-A-0 494 427 beschrieben ist, auf deren Offenbarung hiermit ausdrücklich Bezug genommen wird. Das Gehäuse G dieses Messmoduls ist in Fig. 2 strichpunktiert eingezeichnet.

Der Spulenkörper 3 der zylindrischen Sekundärspule 2 besteht aus einem zylindrischen Kern und zwei Stirnflanschen. An den einen dieser Stirnflansche, und zwar an den in den Fig. 1 und 2 oberen, schliesst ein erster, mit den Stirnflanschen durchmessergleicher zylindrischer Teil 9, und an diesen ein zweiter zylindrischer Teil 10 von grösserem Durchmesser an. Der erste zylindrische Teil 9 und der an diesen anschliessende Bereich des zweiten zylindrischen Teils 10 ist an einer Seite abgeflacht, vorzugsweise auf das Niveau des Kerns des Spulenkörpers 3, so dass ein vom Spulenkörper 3 bis in den zweiten zylindrischen Teil 10 reichender Steg 11 gebildet ist.

Der Spulenkörper 3 und die beiden zylindrischen Teile 9 und 10 sind einstückig hergestellt, vorzugsweise gespritzt, und bilden einen Bauteil. Der zweite zylindrische Teil 10 mit dem grösseren Durchmesser bildet quasi einen Griff zur Handhabung dieses Bauteils und dient als die Axiallage der Sekundärspule 2 im Kupferrohr 4 fixierender Anschlag.

Auf dem auf dem zweiten zylindrischen Teil 10 angeordneten und aus dem Kupferrohr 4 nach aussen ragenden Teil des Stegs 11, sind zwei steckerartige Kontaktelemente 12 zum Anschluss der Sekundärspule 2 an eine Auswerteelektronik (nicht dargestellt) angeordnet. Die beiden Enden des Wickeldrahts 13 der Sekundärspule 2 sind vom Spulenkörper 3 axial nach aussen zu den Kontaktelementen 12 geführt, was bereits auf der die Sekundärspule 2 herstellenden Wickelmaschine erfolgt.

Zwischen den Kontaktelementen 12 und dem Spulenkörper 3 sind auf dem Steg 11 Nocken 14 zur Führung des Wickeldrahts 13 vorgesehen. Die Zu- und Wegleitung des Wickeldrahts 13 sind von der Wickelmaschine gegenläufig um die Nocken 14 gelegt, wodurch die von den Anschlüssen der Sekundärspule 2 aufgespannte Antennenfläche minimiert ist. Somit kann das sonst übliche aufwendige Verdrillen der Anschlussenden des Wikkeldrahts 13 entfallen. Der Steg 11 könnte zusätzlich noch als Träger der Auswerteelektronik dienen, welche in diesem Fall optimal, nämlich möglichst nahe am Entstehungsort des Messsignals plaziert wäre.

Zur Verminderung der kapazitiven Kopplung zwischen Primärleiter 1 und Sekundärspule 2 ist auf der letzteren eine einseitig geerdete Schirmwicklung 15 vorgesehen, welche durch eine vom Wickeldraht 13 der Sekundärspule 2 abgeklemmte Wickellage auf der Sekundärspule gebildet ist.

Wie den Fig. 1 bis 3 weiter entnommen werden kann, ist zwischen Primärleiter 1 und Sekundärspule 2 eine elektrische Isolation 16 vorgesehen, die wegen der schon erwähnten Eigenstabilität der Anordnung keine besonderen Festigkeitsanforderungen zu erfüllen braucht. Darstellungsgemäss ist die Isolation 16 schlauch- oder rohrförmig ausgebildet und überragt in der Länge den Primärleiter 1, dessen axiale Länge etwa doppelt so gross ist wie diejenige der Sekundärspule 2. Als Material für die Isolation 16 wird vorzugsweise Polybuthylenterephtalat oder Polycarbonat verwendet, die Dicke der Isolation 16, welche eine bestimmte Stossspannungsfestigkeit aufweisen muss, beträgt etwa 0,6 Millimeter.

Gegen magnetische Fremdfelder ist der Messwandler durch eine das Kupferrohr 4 von aussen umgreifende magnetische Abschirmung 17 abgeschirmt, welche gegen das Kupferrohr 4 durch eine folienartige Isolationsschicht 18 isoliert ist. Die Abschirmung 17 ist entweder durch zwei ineinandergeschachtelte U-Profile aus weichmagnetischem Material, vorzugsweise u-Metall, oder durch eine um die Isolationsschicht 18 gewickelte, selbstklebende, weichmagnetische Folie gebildet, wobei im Fall dieser Folie eventuell Sättigungsprobleme auftreten können. Als Material für die Isolationsschicht 18 wird vorzugsweise Polyester verwendet.

Diese Art der magnetischen Abschirmung hat den Vorteil, dass sie auf den fertig montierten Messwandler appliziert werden kann und somit dessen Montage nicht beeinträchtigt. Eine Variante bestünde darin, ein ein- oder mehrlagiges Rohr aus dünnem ferromagnetischem Blech zu wickeln und über das die Isolationsschicht 18 tragende Kupferrohr 4 zu schieben, was allerdings vor dem Verlöten des Kupferrohrs 4 mit den Flachprofilen 7 erfolgen müsste.

Der beschriebene Messwandler zeichnet sich durch Robustheit und hohe Eigenstabilität aus und ist einfach im Aufbau und in der Montage. Die Ausbildung des Primärleiters als Kupferrohr mit der schraubenförmig eingefrästen Nut ermöglicht zudem eine einfache Optimierung des Primärleiters auf die maximal zu messende Stromstärke durch entsprechende Anpassung der Steigung der Nut. Ausserdem kann durch Variation der Nutensteigung über die Rohrlänge die Homogenität des Feldes innerhalb des Messwandlers beeinflusst werden.

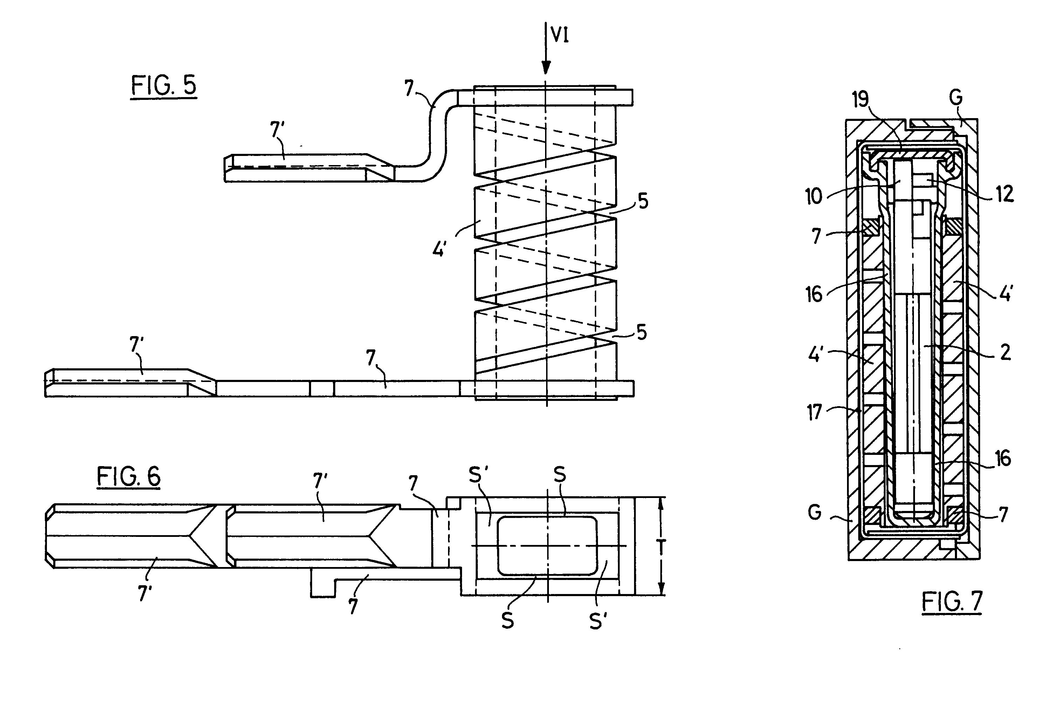

Bei dem in den Fig. 5 bis 7 dargestellten Ausführungsbeispiel ist der Primärleiter 1 nicht durch ein Rohr mit rundem sondern durch ein Hohlprofil 4' mit rechteckigem Querschnitt gebildet. Selbstverständlich weist auch die Sekundärspule 2 einen entsprechenden rechteckigen Querschnitt auf. Da die zum Einbau des Messwandlers zur Verfügung stehende Breite des Gehäuses G vorgegeben ist, ist auch die entsprechende Dimension des Primärleiters vorgegeben. Diese Dimension ist im Fall des runden Rohres 4 dessen Aussendurchmesser und im Fall des rechteckigen Hohlprofils 4' dessen schmälere Breite T. Da ein Kreis einen kleineren Querschnitt hat als ein diesem Kreis umschriebenes Rechteck, ist die Länge des auf der Sekundärspule 2 mit rechteckigem Querschnitt aufgewickelten Drahtes grösser als die auf der runden Sekundärspule aufgewickelte Drahtlänge. Das bedeutet, dass ein definierter Strom im Primärleiter in der rechteckigen Sekundärspule ein grösseres Signal induziert als in der runden.

Neben diesem messtechnischen Vorteil hat der in den Fig. 5 bis 7 dargestellte Messwandler noch den weiteren Vorteil, dass die Nut 5 wesentlich einfacher herzustellen ist als im Fall des runden Rohres 4. Wenn diese Nut, sowie aus Fig. 5 ersichtlich ist, vier Windungen aufweist, dann sind in jede Wand des Hohlprofils 4' vier Nuten einzufräsen. Dies erfolgt am einfachsten mit vier beabstandeten Scheibenfräsern, die die vier Nuten gleichzeitig in eine der längeren Seitenwände S einfräsen, wobei die Frästiefe der Hälfte der Breite T der kürzeren Seitenwände S' entspricht. Nach einer Drehung des Hohlprofils 4' im 180_{°} um seine Längsachse, werden in einem zweiten Arbeitsgang in die andere längere Seitenwand S und in die zweite Hälfte der kürzeren Seitenwände S' ebenfalls vier Nuten gefräst, so dass bei Beendigung dieses zweiten Arbeitsgangs die gewünschte Nut 5 mit vier Windungen gebildet ist.

Aus den Fig. 5 und 6 ist ersichtlich, dass die Flachprofile 7 einen rinnenförmigen Endteil 7' aufweisen, der Bestandteil der Anschlussklemme für die jeweils anzuschliessende Litze bildet (siehe dazu die schon zitierte EP-A-0 494 427).

Aus Fig. 7 ist eine Variante der in Fig. 2 dargestellten Isolation 16 zwischen Primärleiter 1 und Sekundärspule 2 ersichtlich. Darstellungsgemäss ist die Isolation 16 als ein den Messwandler allseitig umschliessender Köcher ausgebildet. An den in Fig. 7 unteren Ende ist der die Isolation 16 bildende Köcher mit einem Boden versehen, und an dem in der Figur oberen Ende ist eine Auskragung mit einer Vertiefung vorgesehen, in der ein Deckel 19 fixierbar ist. Diese Variante hat den Vorteil, dass die Sekundärspule 2 optimal geschützt ist.

## Patentansprüche

1. Messwandler für statische Elektrizitätszähler, mit einem den zu messenden Strom führenden Primärleiter und mit einer mit diesem magnetisch gekoppelten Sekundärspule, dadurch gekennzeichnet, dass der Primärleiter (1, 1') schraubenförmig ausgebildet ist und einen Körper in der Art einer Spiralfeder bildet, welcher die Sekundärspule (2) mit mindestens einer Windung umfasst.

2. Messwandler nach Anspruch 1, dadurch gekennzeichnet, dass der genannte durch den Primärleiter (1) gebildete Körper durch ein Rohr (4) mit einer dessen Wandung durchstossenden, schraubenförmigen Nut (5) gebildet ist.

3. Messwandler nach Anspruch 2, dadurch gekennzeichnet, dass das Rohr (4) an seinen Enden mit der Stromzu- und -wegleitung dienenden Schienen (7) leitend verbunden ist.

4. Messwandler nach Anspruch 3, dadurch gekennzeichnet, dass die Schienen (7) durch ein bandartiges Flachprofil gebildet und dass die Enden des Rohres (4) in Bohrungen der Schienen eingesetzt und mit diesen verlötet sind.

5. Messwandler nach Anspruch 2, dadurch gekennzeichnet, dass die Nut (5) eine sich über die Länge des Rohres (4) ändernde Steigung aufweist.

6. Messwandler nach Anspruch 1, dadurch gekennzeichnet, dass der genannte durch den Primärleiter (1') gebildete Körper durch ein durch Biegung geformtes Band (6) gebildet ist.

7. Messwandler nach einem der Ansprüche 1 bis 6, dadurch gekennzeichnet, dass die Sekundärspule (2) einen Wickelkörper (3) aufweist, an welchen in axialer Richtung ein den durch den Primärleiter (1, 1') gebildeten Körper seitlich überragender Fortsatz (9, 10) angearbeitet ist.

8. Messwandler nach Anspruch 7, dadurch gekennzeichnet, dass der genannte Fortsatz (9, 10) eine zylindrische Form aufweist und einen als Anschlag wirkenden Teil (10) besitzt, durch welchen der aus der Sekundärspule (2) und dem Fortsatz bestehende Bauteil im Primärleiter (1, 1') in axialer Richtung positioniert ist.

9. Messwandler nach Anspruch 8, dadurch gekennzeichnet, dass der den Fortsatz (9, 10) bildende Zylinder mit einer Abflachung (11) versehen und dadurch stegförmig ausgebildet ist, und dass auf der Abflachung steckerförmige Anschlüsse (12) für die Sekundärspule (2) angeordnet sind.

10. Messwandler nach Anspruch 9, dadurch gekennzeichnet, dass auf der Abflachung (11) Nocken (14) zur Führung der von der Sekundärspule (2) zu den Anschlüssen (12) verlaufenden Enden des Wickeldrahts (13) angeordnet, und dass die Enden des Wickeldrahts gegenläufig um die Nocken gelegt sind.

11. Messwandler nach Anspruch 7, gekennzeichnet durch eine zwischen dem Primärleiter (1, 1') und der Sekundärspule (2) angeordnete rohr- oder schlauchartige Isolierung (16).

12. Messwandler nach Anspruch 7, gekennzeichnet durch eine den Primärleiter (1, 1') umgreifende magnetische Abschirmung aus weichmagnetischem Material, vorzugsweise aus u-Metall.

13. Messwandler nach Anspruch 12, dadurch gekennzeichnet, dass die magnetische Abschirmung durch schachtelartig ineinandergreifende Teile (17) eines U-förmigen Blechprofils gebildet ist.

14. Messwandler nach Anspruch 12, dadurch gekennzeichnet, dass die magnetische Abschirmung durch ein um den Primärleiter (1, 1') gewickeltes Blechband gebildet ist.

15. Messwandler nach einem der Ansprüche 12 bis 14, gekennzeichnet durch eine zwischen dem Primärleiter (1, 1') und der magnetischen Abschirmung angeordnete, folienartige Isolation (18).

16. Messwandler nach Anspruch 1, dadurch gekennzeichnet, dass der durch den Primärleiter gebildete Körper durch ein Hohlprofil (4') mit rechteckigem Querschnitt gebildet ist, und dass die Sekundärspule (2) ebenfalls einen rechteckigen Querschnitt aufweist.

17. Messwandler nach den Ansprüchen 11 und 16, dadurch gekennzeichnet, dass die Isolierung (16) die Form eines mit einem Deckel (19) verschliessbaren Köchers aufweist und die Sekundärspule (2) sowie den an deren Wickelkörper (3) angearbeiteten Fortsatz (9, 10) umschliesst.
